Europäisches Patentamt

(19) European Patent Office

Office européen des brevets

(11) Publication number: **0 090 612**
**B1**

## (12) EUROPEAN PATENT SPECIFICATION

(45) Date of publication of patent specification: **21.06.89**

(51) Int. Cl.⁴: **H 01 L 39/24**

(21) Application number: **83301677.7**

(22) Date of filing: **25.03.83**

(54) Method of making Josephson junction devices.

(30) Priority: **26.03.82 US 362578**

(43) Date of publication of application:
**05.10.83 Bulletin 83/40**

(45) Publication of the grant of the patent:
**21.06.89 Bulletin 89/25**

(84) Designated Contracting States:
**CH DE FR GB IT LI NL**

(56) References cited:
**EP-A-0 013 130**
**FR-A-2 392 495**
**US-A-3 858 304**
**US-A-4 218 532**

**PATENTS ABSTRACTS OF JAPAN, vol. 5, no.
159 (E-77)831r, 14th October 1981; & JP - A - 56
88 384 (HITACHI SEISAKUSHO K.K.) 17-07-1981**

(73) Proprietor: **SPERRY CORPORATION**
**1290, Avenue of the Americas**
**New York, N.Y. 10019 (US)**

(72) Inventor: **Lung-Chung Young, Peter, Dr.**
**224 Old Church Road**
**North Wales Pennsylvania 19454 (US)**
Inventor: **Stein, Barry F., Dr.**
**1650 Limerick Lane**
**Dresher Pennsylvania 19025 (US)**
Inventor: **Sheppard, John Edward**
**3716 Knights Road**
**Cornwells Heights Pennsylvania 19020 (US)**

(74) Representative: **Orchard, Oliver John**
**JOHN ORCHARD & CO. Staple Inn Buildings**
**North High Holborn**
**London WC1V 7PZ (GB)**

Courier Press, Leamington Spa, England.

## Description

The invention relates to a method of making Josephson junction devices.

Josephson junction devices are normally made by a process of depositing layers of metal and insulator in a vacuum. The layers are patterned as necessary to form conductors and electrodes for the Josephson junctions, and this is normally done by means of a mask formed by a photoresist as is well known in the art.

To achieve high packing density on a substrate the areas of the base electrodes of the Josephson junctions are small and they are positioned close together, and when subsequent layers are applied they follow the contours of the base electrode layer and provide an undulating surface. This is disadvantageous for a number of reasons. It reduces photolithographic resolution and line width control, it reduces control of electrical parameters such as capacitance, inductance, and stripline impedance, and it provides areas of locally concentrated stress when Josephson junctions are cycled between operating temperatures and room temperatures.

It is an object of the invention to reduce this effect.

Methods are known for planarising semiconductor devices, for example by the use of thick layers of photoresist, or by the use of polyamic acid which is cured to form a polyimide layer. However, these methods are not applicable to Josephson junction devices because of the extreme temperatures to which such devices are subject.

In Patent Abstracts of Japan, vol 5, no 159 there is described a method according to the introductory portion of claim 1.

The invention is defined in the claims appended hereto.

The insulator layer may be deposited first, and a negative photoresist mask may be used, exposing the areas to be occupied by the metal layer. The insulator may then be etched away, by, for example, a plasma etching process, leaving the edges of the mask undercut, and metal may be deposited to occupy the place of the removed insulating material to such a depth as to leave the overhanging ledge as before, the process being completed by removal of the mask.

The process may be applied to layers other than the base electrode layer, in particular, it may be used for the layer forming the counter electrode of one or more Josephson junctions.

The method of carrying out the invention will now be described with reference to the accompanying drawings, in which

Figure 1 is an enlarged schematic cross-section of a Josephson junction device manufactured according to prior art methods.

Figure 2 is an enlarged cross-section of a Josephson junction device manufactured by the method of the present invention.

Figure 3 is a cross section illustrating the first of the steps in making the junction of Figure 2.

Figures 4 to 9 show successive stages of the manufacture of a Josephson junction by the method of the invention, and

Figures 10 and 11 illustrate a modification of the method described with reference to Figures 2 to 9.

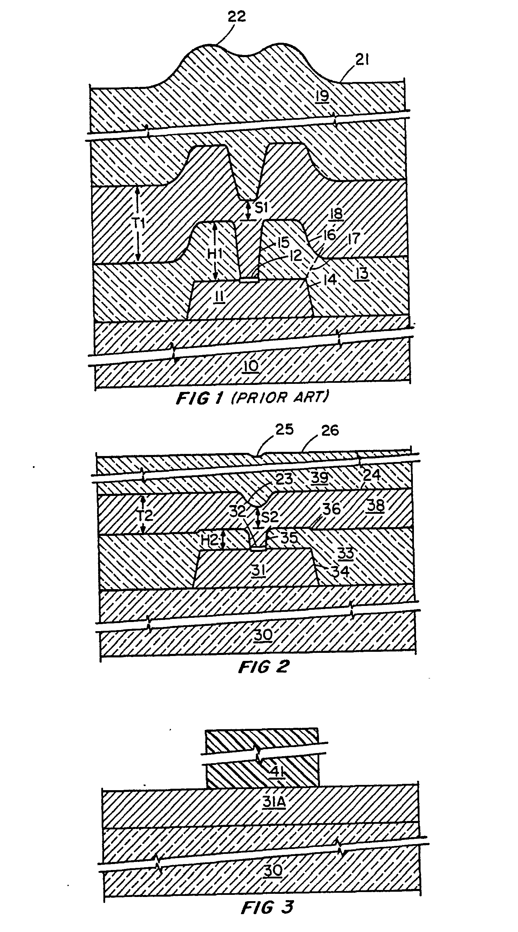

Figure 1 of the drawings is an enlarged cross-section of a typical prior art Josephson junction. Wafer 10 is the substrate upon which the layers will be applied. Preferably for Josephson junction applications, the wafer 10 comprises a high purity flat silicon wafer having a silicon oxide nonporous layer thermally-grown on the top surface. Such wafers are well known in the prior art, and typically may be ten mils (250 micro-meters) in thickness and two to five inches (5 to 12 cm) in diameter. The base electrode 11 is usually made from a lead alloy, or from niobium, and formed by vacuum deposition. Such layers are preferably around 2000 Å (200 nm) thick. On the base electrode a small area is isolated and the barrier tunnel junction 12 is formed thereon, preferably by radio frequency oxidation. Such barrier tunnel junction layers are partially formed into the base electrode layer and partially above the base electrode layer, to a thickness of around 40 Å (4 nm). A silicon oxide layer 13 is formed over the step 14 of the base electrode 11 and covers the top of the base electrode except for the barrier tunnel junction 12. Typically, the thickness of the silicon oxide layer 13 is approximately 3000 Å (300 nm). The step 15 is substantially linear and steep in shape whereas the step 16 forms in a smooth contour above the step 14. However, the distance between the top of the step and the smooth contour 16 as shown at line 17 is substantially less than 3000 Å (300 nm) and in this area stress concentration can cause failures. After the silicon oxide layer 13 is deposited over the desired areas of the substrate 10 and the base electrode 11, a counter electrode 18 is deposited over the entire surface shown in Figure 1. The shape of the counter electrode 18 is determined by the remainder of the device (not shown) but it must make connection to the barrier tunnel junction 12. Preferably, the counter electrode 18 is approximately 4000 Å (400 nm) thick, and is made from a superconducting material such as lead alloy or niobium. After the counter electrode 18 is made, the active Josephson junction is the tunnel barrier junction 12 sandwiched between base electrode and the counter electrode. Leads (not shown) attached to the base electrode 11 and counter electrode 18 provide means for connecting the Josephson junction device to a circuit. To protect the Josephson junction device, a passivation layer 19 is applied over the counter electrode 18. Preferably, the passivation layer 19 is made from silicon oxide and in the prior art is made approximately two micrometers thick (20,000 Å). In the prior art Josephson junction device, it will be noted that the thickness of the counter electrode 18, shown as T1, must be made greater than the height H1, to achieve the separation S1 at the critical step 15 above the tunnel barrier junction 12. As will be explained hereinafter, the thickness of the counter electrode 18 is made thicker than would be desirable which causes the layer to be more susceptible to damage by thermal cycling, and also tends to increase the grain size of the counter electrode material, which causes the layer to also be more susceptible to failure at the barrier junction 12 due to thermal cycling. As will be explained hereinafter, the passivation layer 19 is also made thicker than optimum, in order to make the top surface 21 smooth over the step 15 as shown at contour 22.

Figure 2 is an enlarged cross-section of a preferred embodiment Josephson junction made by the method of the present invention. The wafer 30 corresponds to the wafer 10 and the base electrode 31 to the base electrode 11. Also the barrier tunnel junction 32 is formed as previously described with reference to barrier tunnel junction 12 of Figure 1. The silicon oxide insulation layer 33 is formed in such a manner that the total thickness is only approximately 2600 Å (260 nm), even though it is formed over the same step 34 as the step 14. The insulation tunnel junction step 35 is now substantially reduced in height and the insulation base electrode step 16 shown at point 36 has been virtually eliminated. Thus, there is no stress line concentration over the step, as occurred in the prior art and shown at line 17. When the counter electrode layer is formed over the insulation layer after forming the barrier tunnel junction 32, it may be made only approximately 2000 Å (200 nm) thick which is the optimum thickness for this electrode 38. Even though the top surface 24 of the base electrode has a contour 23 which is smooth, it still maintains the same or even greater separation S2 as before, although the thickness T2 and the height H2 have been substantially reduced. Further, the passivation layer 39 may now be made only approximately 5000 Å (500 nm) thick which is most desirable both for electrical properties and reducing stress concentrations. The contour 25 in the top surface 26 of passivation layer 39 is virtually eliminated, but is shown exaggerated to illustrate that such contour may occur. The thickness of the layers of the Josephson junction device have been optimised, while virtually eliminating stress concentration points which cause cracking and electrical failure.

Figure 3 shows the first of the series of steps in making the Josephson junction shown in Figure 2. The substrate 30 carries a complete and uniform layer of base electrode material 31. On the base electrode material 31 is a photoresist pattern 41 in rectangular shape, made by applying a complete layer, and treating the photoresist in such a manner that only the pattern 41 remains. No special new technique is employed at this point to achieve the shape of the photoresist profile.

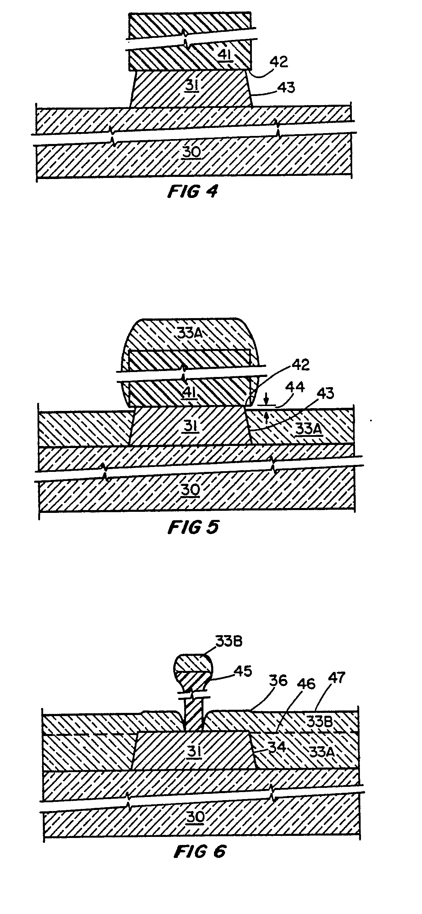

Figure 4 shows the same photoresist pattern 41 after the base electrode material 31 has been isotropically etched to provide an undercut ledge 42 under the photoresist 41. The tapered shape 43 of the side of the base electrode material 31 is shown linear for schematic purposes, even though it is well known that isotropic etching causes a rounded contour. Since the thicknesses of the layers being described are so small compared to the width of the base electrode 31 and the pattern of photoresist 41, it is impossible to show this in proper perspective. Only after the base electrode 31 is shaped to form the undercut ledge 42 can the silicon oxide layer 33A be applied by vacuum deposition. The vacuum deposited silicon oxide layer 33A is shown in Figure 5 covering the exposed wafer surface 30 and filling in the undercut sides 43 of the base electrode 31. Instead of making the silicon oxide layer 33A the same height as the base electrode 31, the layer is made thinner by approximately 400 Å (40 nm) leaving a gap 44 which exposes the ledge 42 of photoresist 41. It will be noted that the silicon oxide layer 33A has formed on top of the photoresist pattern 41, and also along the sides of the photoresist pattern 41, but has not formed in the gap area 44, thus producing a discontinuity of the silicon oxide material completely around the photoresist pattern 41. In the preferred embodiment method to be described in more detail hereinafter, the thickness of the gap 44 need only be sufficient to ensure that the gap 44 extends completely around the photoresist 41 to ensure that solvent material can enter into the gap and reach the ledge 42 and dissolve the photoresist pattern 41. This method, in which the pattern 41 and the silicon oxide on top of the pattern 41 is removed, is known as the lift-off technique.

Figure 6 shows the structure of Figure 5 after the pattern 41 and the silicon oxide layer 33A thereon has been removed by the lift-off technique. After removing the photoresist 41, a new photoresist mushroom-shaped pattern 45 is applied to define the barrier junction area. Mushroom-shaped photoresist patterns are well known, and that in the preferred embodiment shown here is from 5000 Å to 10,000 Å (500 to 1000 nm) thick. This thickness is less than is required in the prior art, as will be explained hereinafter. After forming the mushroom shape photoresist pattern 45, it is now possible to evaporate and deposit the second silicon oxide layer 33B. The boundary between the layers 33A and of 33B is shown as the dotted line 46, however, the two layers 33A and 33B form as a continuous layer 2600 Å (200nm) thick. The second silicon oxide layer 33B is preferably only 1000 Å (100 nm) thick and forms on top of the mushroom shape photoresist pattern 45, leaving the sides of the pattern exposed. The contour 36 over the step 34 is shown exaggerated in this view. In the preferred Josephson junction device using a gap 44 of 400 Å, (40 nm) this contour is smooth and less than 200 Å (20 nm) in height. Smoothing of the contour 36 and virtually eliminating the step at this point results in an almost flat surface 47 at the top of the silicon oxide layer 33, except at the junction 32.

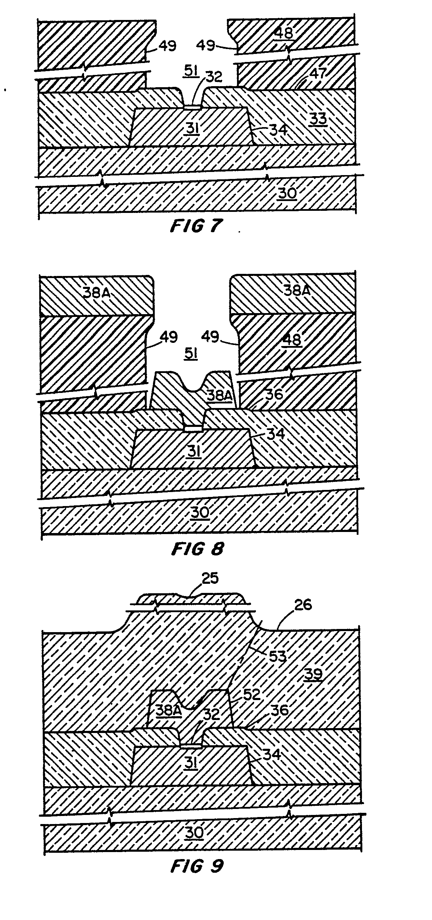

Figure 7 shows the partially completed Josephson junction device after the mushroom shape photoresist pattern 45 and the silicon oxide layer 33B have been removed, and a third photoresist pattern 48 has been applied on top of the surface 47 of the silicon oxide insulation layer 33. The inner edges 49 of the photoresist pattern 48 are made by the same techniques applied to the mushroom pattern 45, providing a suitable lift-off profile. The two edges 49 now define the limits of an aperture 51 which establishes the width and line parameters for the counter electrode which will be deposited at a later step. Before depositing the counter electrode, oxygen is introduced into the system and by radio frequency oxidation the barrier tunnel junction 32 is formed on top of the base electrode 31. As previously mentioned, the barrier tunnel junction forms partially into the base electrode material and partially above the base electrode 31. Without having to remove the partially complete Josephson junction device from the vacuum chamber system, it is now possible to continue with vacuum deposition steps and to evaporate and deposit the counter electrode .

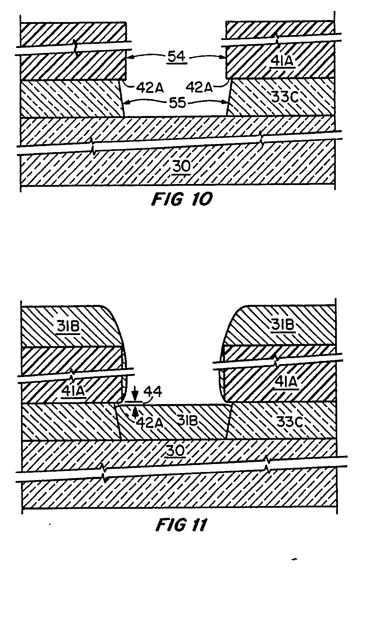

Figure 8 shows the structure of Figure 7 after the counter electrode 38A has been deposited. The photoresist pattern 48 is narrower at the top than at the sides 49 of the aperture, so allowing the counter electrode to form without touching the edges 49 of the photoresist pattern 48. The counter electrode 38A may be formed as a series of layers of different metals and then annealed to form a homogeneous alloy, or may be deposited as an alloy or a pure material. For example, a preferred method of forming the base electrode 31 and counter electrode 38A is to apply layers of lead, gold, indium and bismuth in a desired combination. After applying the desired layers in a desired thickness these base electrodes 31 and counter electrodes 38 may be annealed to form a homogeneous electrode material, as is well known in this art. After the counter electrode 38A is formed, the photoresist pattern 48 and counter electrode material 38A thereo nmay be removed by the lift-off technique.

Figure 9 shows the partially complete Josephson junction device of Figure 8 after the photoresist pattern 48 has been removed and a passivation layer 39 has been deposited. In one Josephson junction device made according to the invention, the passivation layer 39 was made 5000 Å (500 nm) thick and not 20,000 Å (2000 nm) thick, as would have been required for prior art devices. The Figure 9 shows an exaggerated step 34 on the base electrode 31. The counter electrode 38A has been made the same thickness as the base electrode 31, and also involves a steep step 52 as a result of vacuum deposition. Since the step 52 is not as high as the prior art step 15 of Figure 1, the passivation layer 39 need not be made as thick as in the prior art to ensure that the top surface 26 has a substantial smoothing effect over the counter electrode 38A and reduces the stress concentration which occurs along the counter electrode stress line 53. Further, the contour 25 which is opposite the barrier tunnel junction 32 is substantially reduced, if not smooth. The Josephson junction devices shown in Figures 2 and 9 are shown on a different vertical scale to illustrate the most extreme step 52 in Figure 9. Even with the extreme step 52 at the side of the counter electrode 38A, it ispossible to reduce the thickness of the passivation layer 39 to reduce stresses and avoid cracking, which would expose the electrode to potentially corrosive atmospheres.

Figures 10 and 11 show a modification of the above method. The photoresist pattern 41 shown in Figure 3, which was applied to the continuous layer of base electrode material 31, may be modified in order to form a substantially identical base electrode 31 by the technique described below. A photoresist pattern 41A is applied on top of a silicon oxide layer 33C to provide an aperture 54 which exposes a portion of the silicon oxide layer 33. In Figure 10, plasma etching through the aperture 54 in the photoresist pattern 41A permits the formation of a base electrode aperture 55 in the silicon oxide 33C. After the base electrode aperture 55 is formed so as to provide undercut ledges 42A, the photoresist pattern 41A is left in place and the base electrode 31B is formed by vacuum deposition of the base electrode materials as above. The deposition of the base electrode 31B also causes deposits of the base electrode material to form on top of the photoresist and marginally on the edges of the photoresist pattern 41A. As long as the gap 44 is provided above the top of the base electrode 31B, it is possible for solvent to be introduced under the photoresist pattern 41A at ledge 42A. After the formation of the base electrode 31B by the modified technique described above, the same steps which are required after Figure 5 of the preferred embodiment are performed to produce a substantially equivalent Josephson junction device. This is to say, the photoresist pattern 41A and material 31B thereon is stripped away, leaving the planarised surface comprising the tops of the base electrode and the adjacently deposited silicon oxide layers.

In the embodiments described above, the substrate 30 was placed opposite a series of boats containing the material to be deposited on the substrate 30. The substrate was offset and mounted on a rotary platform so as to assure that the materials being deposited under the ledges 42 and 42A of the photoresist patterns 41 and 41A filled in completely to provide asubstantially flat top to the base electrodes 31 and 31B.

The same method of planarising while performing vacuum deposition steps in a vacuum chamber system may also be applied to the counter electrode and other layers of the Josephson junction devices.

**Claims**

1. A method of making a Josephson junction device in which layers of metal and insulator are formed on a substrate by deposition in vacuum, and in which at least a layer providing an electrode of the Josephson junction is formed into a pattern defined by a photoresist mask, the method including the steps of

(a) depositing a first layer of metal (or insulator);

(b) forming thereon a photoresist mask defining the outline of a conductive pattern;

(c) removing the material of the unmasked areas of the layer;

(d) depositing a complementary layer of insulator (or metal) to occupy the place of the removed material, and

(e) removing the mask with the aid of a solvent, characterised in that

(i) the material of the unmasked areas of the first layer is removed in such a way as to leave the edges of the mask undercut;

(ii) the complementary layer is made thinner than the first layer by an amount sufficient to produce a discontinuity around the photoresist pattern, thereby allowing the solvent in step (e) to penetrate under the undercut edges of the mask, and

(iii) during deposition of the complementary layer the substrate is inclined to the direction from which material is being evaporated and is rotated to ensure that material can deposit under the overhanging edges of the mask.

2. A method according to claim 1 in which the patterned layer is of metal and provides the base electrode of one or more Josephson junctions.

3. A method according to claim 1 or claim 2 in which the said first layer is of insulating material, and the portion exposed by the mast are removed by plasma etching.

**Patentansprüche**

1. Verfahren zur Herstellung eines Bauelements mit Josephson-Übergang, bei dem Metall- und Isolatorschichten auf einem Substrat durch Vakuumabscheidung gebildet werden und bei dem zumindest eine Schicht, die eine Elektrode des Josephson-Übergangs schafft, in einer durch eine Photoresistmaske definierten Struktur ausgebildet wird, wobei das Verfahren die folgenden Schritte enthält:

(a) Abscheiden einer ersten Metallschicht (oder Isolatorschicht);

(b) darauf Ausbilden einer Photoresistmaske, die den Umriß einer leitfähigen Struktur festlegt;

(c) Entfernen des Materials der unmaskierten Bereiche der Schicht;

(d) Abscheiden einer komplementären Isolatorschicht (oder Metallschicht), um den Platz des entfernten Materials zu belegen; und

(e) Entfernen der Maske mit Hilfe eines Lösungsmittels;

dadurch gekennzeichnet,

(i) daß das Material der unmaskierten Bereiche der ersten Schicht so entfernt wird, daß die Ränder der Maske unterschnitten zurückbleiben;

(ii) daß die komplementäre Schicht um einen Betrag dünner als die erste Schicht gemacht wird, der ausreicht, um die Photoresiststruktur herum eine Diskontinuität zu erzeugen, wodurch das Lösungsmittel in Schritt (e) unter die unterschnittenen Ränder der Maske eindringen kann; und

(iii) daß während der Abscheidung der komplementären Schicht das Substrat in die Richtung geneigt wird, aus der Material verdampft wird, und gedreht wird, um sicherzustellen, daß sich Material unter den überhängenden Rändern der Maske niederschlagen kann.

2. Verfahren nach Anspruch 1, bei dem die strukturierte Schicht aus Metall ist und die Basiselektrode von einem oder mehreren Josephson-Übergängen schafft.

3. Verfahren nach Anspruch 1 oder Anspruch 2, bei dem die erste Schicht aus isolierendem Material ist und die durch die Maske freigelegten Bereiche durch Plasmaätzen entfernt werden.

**Revendications**

1. Procédé de fabrication d'un dispositif à jonction Josephson, dans lequel des couches de métal et de diélectrique sont formées sur un substrat par dépôt sous vide, et dans lequel au moins une couche constituant une électrode de la jonction Josephson est formée selon une configuration définie par un masque photorésistif, ce procédé comprenant les étapes consistant à:

a) déposer une première couche de métal (ou de diélectrique),

b) former par-dessus un masque photorésistif définissant le contour d'une configuration conductrice,

c) enlever la matière des zones non masquées de la couche,

d) déposer une couche complémentaire de diélectrique (ou de métal) de sorte qu'elle occupe la place de la matière enlevée, et

e) éliminer le masque à l'aide d'un solvant, caractérisé en ce que

i) la matière des zones non masquées de la première couche est enlevée de manière à laisser des bords en contre-dépouille du masque,

ii) la couche complémentaire est formée de façon à être plus mince que la première couche, dans une mesure suffisante pour créer une discontinuité autour de la configuration photorésistive, de manière à permettre au solvant utilisé dans l'étape (e) de pénétrer sous les bords en contre-dépouille du masque, et

iii) pendant le dépôt de la couche complémentaire, on incline le substrat vers la direction à partir de laquelle la matière est évaporée et on le fait tourner pour s'assurer que la matière pourra se déposer sous les bords en surplomb du masque.

2. Procédé selon la revendication 1, dans lequel la couche à configuration est en métal et constitue l'électrode de base d'une ou de plusieurs jonctions Josephson.

3. Procédé selon la revendication 1 ou 2, dans lequel ladite première couche est en matière isolante et les parties dégagées par le masque sont enlevées par gravure par plasma.

FIG 1 (PRIOR ART)

FIG 2

FIG 3

1

EP 0 090 612 B1

FIG 4

FIG 5

FIG 6

**FIG 7**

**FIG 8**

**FIG 9**

**FIG 10**

**FIG 11**

4